# EUROPÄISCHE PATENTSCHRIFT

(11) **EP 0 451 307 B1**
(45) Veröffentlichungstag und Bekanntmachung des Hinweises auf die Patenterteilung: **23.10.1996**
(21) Anmeldenummer: 90106777.7
(22) Anmeldetag: 09.04.1990
(51) Int. Cl.: G03F 1/14

(54) **Phasenmaske für die Projektionsphotolithographie und Verfahren zu deren Herstellung**
Phase mask for photolithographic projection and process for its preparation
Masque à effet de phase pour projection photolithographique et procédé de préparation

(43) Veröffentlichungstag der Anmeldung: 16.10.1991
(73) Patentinhaber: SIEMENS AKTIENGESELLSCHAFT, 80333 München (DE)
(72) Erfinder: Nölscher, Christoph, Dr. rer. nat., Dipl.-Phys., D-8000 München (DE); Mader, Leonhard, Dr. rer. nat., Dipl.-Phys., D-8012 Ottobrunn (DE)

(56) Entgegenhaltungen:
- EP-A- 0 090 924
- EP-A- 0 234 547
- EP-A- 0 383 534
- EP-A- 0 395 425
- PATENT ABSTRACTS OF JAPAN, vol. 11, no. 162 (P-579)(2609) 26 Mai 1987 & JP-A-61 292 643

## Beschreibung

Die Erfindung betrifft eine Phasenmaske für die Projektionsphotolithographie mit Licht einer Wellenlänge λ zum Einsatz in einem Belichtungsgerät mit einem Abbildungsmaßstab m und einer numerischen Apertur NA sowie ein Herstellverfahren für eine solche Phasenmaske.

Bei der Entwicklung von Halbleiterbausteinen werden immer höhere Packungsdichten angestrebt. Das erfordert eine immer weitere Reduzierung der Minimalmaße der einzelnen Elemente. Mit Hilfe heutiger Halbleitertechnologien werden bereits Strukturfeinheiten von unter 1 µm erzielt.

Mit der ständigen Reduzierung der Minimalmaße der einzelnen Elemente sind ständig wachsende Anforderungen an die Strukturierungstechnik verbunden. Insbesondere muß die Auflösung der für die Photolithographie eingesetzten Belichtungsgeräte weiter verbessert werden, um eine maßhaltige Strukturierung zu ermöglichen.

Die Auflösung wird begrenzt durch Beugungseffekte an Strukturrändern einer in dem Belichtungsgerät verwendeten Projektionsmaske. Beim Durchgang des Lichtes durch die Projektionsmaske gelangt ein Teil der durchgehenden Lichtintensität in Folge von Beugungseffekten in Bereiche, die von der Projektionsmaske abgedeckt sind.

Aus M.D. Levenson et al, IEEE ED-29, (1982), p. 1828 ist bekannt, zur Reduktion von Beugungseffekten eine sog. Phaseshifting-Maske oder Phasenmaske verwenden. Eine Phasenmaske ist eine Projektionsmaske, bei der Licht, das benachbarte Öffnungen der Projektionsmaske durchquert hat, in der Phase verschoben ist. Bei dieser bekannten Phasenmaske beträgt die Phasenverschiebung 180°. Dadurch kommt es bei Belichtung mit kohärentem oder teilweise kohärentem Licht zu einer destruktiven Interferenz zwischen den beiden Öffnungen. Diese bewirkt, daß die Intensität zwischen den beiden Öffnungen minimiert wird. Eine Phasenmaske wird dadurch realisiert, daß eine Öffnung in der Projektionsmaske mit einer lichtdurchlässigen Schicht der Dicke d = λ /(2(n-1)), wobei n der Brechungsindex der lichtdurchlässigen Schicht und λ die Wellenlänge des Lichtes ist, versehen wird.

Bei der Herstellung der Phasenmaske wird auf einen Träger, der mit einem Maskenmuster aus lichtabsorbierenden Material versehen ist, eine Schicht aus Elektronenstrahllack aufgebracht. Mit Hilfe von Elektronenstrahllithographie wird diese in der obengeschilderten Art strukturiert. Eine Alternative besteht darin, auf das fertige Maskenmuster eine Schicht aus SiOₓ oder MgF₂ aufzubringen, die mit Hilfe von Elektronenstrahllithographie und anschließendem Trockenätzen strukturiert wird.

Aus T. Terasawa et al, Proc. SPIE 1088 (1989) p. 25 ist eine Phasenmaske bekannt, bei der ebenfalls Elektronenstrahllack verwendet wird, um auf der Maske phasenverschiebende Bereiche zu erzeugen.

Aus I. Hanyu et al, abstract SPIE 1264 (1990) ist eine Phasenmaske bekannt, bei der die phasenverschiebenden Bereiche aus SiO₂ bestehen. Zur Herstellung wird auf der fertigen Maske mit Hilfe von Elektronenstrahllithographie eine Elektronenstrahllackstruktur erzeugt. Auf diese wird eine SiO₂-Schicht aufgebracht. Durch einen Lift-off-Prozeß werden die mit Elektronenstrahllack unterlegten Bereiche der SiO₂-Schicht entfernt.

Aus M. Nakase et al, preprint IEDM (1989) ist eine Phasenmaske bekannt, bei der die phasenverschiebenden Bereiche aus Elektronenstrahllack bestehen. Die phasenverschiebenden Bereiche sind selbstjustiert auf dem lichtabsorbierenden Maskenmuster angeordnet. Der Elektronenstrahllack überragt die lichtabsorbierenden Bereiche der Maske jeweils am Rand. Dadurch enthalten die lichtdurchlässigen Bereiche jeweils einen Saum, der die Lichtphase um 180° verschiebt.

Aus der Arbeit von Prouty et al, Proc. SPIE 470 (1984) p. 228 ist bekannt, daß eine Reduktion der Beugungseffekte schon mit Phasenmasken erzielt wird, die einen Phasenunterschied 180° +/- 60° bewirken.

Dem Verfahren zur Herstellung von Phasenmasken nach Levenson et al, Terasawa et al und Hanyu et al ist gemeinsam, daß sie je zwei Elektronenstrahllithographieprozesse erfordern. Das macht eine aufwendige Ausrüstung zur Herstellung der Masken notwendig. Das Verfahren nach Nakase et al hat den Nachteil, daß es Masken mit phasenverschiebenden Bereichen aus Elektronenstrahllack verwendet. Solche Masken sind schwierig bis unmöglich zu reinigen. Außerdem absorbiert der Lack im tiefen UV und weist darüber hinaus einen zum Maskenträger unterschiedlichen Brechungsindex auf, der zu Vielfachinterferenzen führt. Aus der EP-A-0 383 534 ist eine Phasenmaske für die Projektionsphotolithographie bekannt mit folgenden Merkmalen :
a) es ist ein Träger aus lichtdurchlässigem Material mit einem darauf angeordneten Maskenmuster aus lichtabsorbierendem Material vorgesehen,
b) der Träger weist außerhalb des Maskenmusters erste Bereiche und zweite Bereiche auf, die von dem absorbierenden Material unbedeckt sind,
c) der Träger enthält ein Substrat aus einem lichtdurchlässigen ersten Material (Quarz), dessen Oberfläche in den zweiten Bereichen freiliegt,
d) auf dem Substrat sind strukturen aus einem lichtdurchlässigen zweiten Material ("silicon oxide" oder "polymethylmethacrylate") angeordnet, deren Oberfläche in den ersten bereichen freiliegt.

Der Erfindung liegt die Aufgabe zugrunde, eine Phasenmaske anzugeben, die ohne zusätzliche Elektronenstrahllithographie herstellbar und leicht zu reinigen ist. Des weiteren ist es Aufgabe, ein Herstellverfahren für eine solche Maske anzugeben.

Die Aufgabe wird erfindungsgemäß gelöst durch eine Phasenmaske für die Projektionsphotolithographie mit Licht einer Wellenlänge λ zum Einsatz in einem Belichtungsgerät mit einem Abbildungsmaßstrab m und einer numerischen Apertur NA wie im Patentanspruch 1 beansprucht.

Die unterschiedliche optische Dicke des Trägers der im Patentanspruch 1 beanspruchten Phasenmaske in den ersten Bereichen und in den zweiten Bereichen bewirkt, daß Licht nach Durchgang durch die ersten Bereiche und Licht nach Durchgang durch die zweiten Bereiche gegeneinander phasenverschoben ist. Die Phasenverschiebung liegt dabei in dem Bereich 180° +/- 60°. Für die Erfindung wesentlich ist, daß die phasenverschiebenden Bereiche im Träger der Phasenmaske selbst realisiert sind.

Die Unterdrückung von Beugungseffekten ist optimal bei einer Phasenverschiebung von 180°.

In seiner Ausführungsform besteht der Träger aus einem Substrat aus einem lichtdurchlässigem ersten Material, dessen Oberfläche in den zweiten Bereichen freiliegt. Auf dem Substrat sind Strukturen aus einem lichtdurchlässigen zweiten Material angeordnet, deren Oberfläche in den ersten Bereichen freiliegt. Das zweite Material ist so gewählt, daß es in einem anisotropen Ätzprozeß selektiv zur Substratoberfläche ätzbar ist. Dabei liegt es im Rahmen der Erfindung das Substrat aus Quarz mit einer ätzresistenten Deckschicht aus z. B. Si₃N₄ und die Strukturen aus Quarz vorzusehen. Es liegt ferner im Rahmen der Erfindung, das Substrat aus Saphir und die Strukturen aus mindestens einen der Stoffe SiO₂ und Si₃N₄ vorzusehen.

Diese Ausführungsform hat den Vorteil, daß beim anisotropen Ätzen in den Träger zur Erzeugung der zweiten Bereiche auf dem Substrat ein Ätzstopp gegeben ist.

In einer Ausgestaltung der Erfindung gibt es zweite Bereiche, die ringförmig von einem der ersten Bereiche unmittelbar benachbart umgeben sind. Diese Ausführungsform hat den Vorteil, daß sie in einem selbstjustierten Herstellverfahren herstellbar ist.

Die Aufgabe wird weiterhin gelöst durch ein Herstellverfahren für eine Phasenmaske für die Projektionsphotolithographie gemäß Patntanspruch 5.

Es liegt im Rahmen der Erfindung, die ersten Bereiche dadurch zu erzeugen, daß die lichtabsorbierende Schicht bei der isotropen Ätzung unter die strukturierte Photolackschicht zurückgeätzt wird. Es entsteht dabei ein Bereich des Trägers, in dem die Trägeroberfläche unter den Photolackstrukturen freigelegt ist. Bei der Herstellung der zweiten Bereiche durch anisotrope Ätzung wird die Ausdehnung der Photolackstruktur auf die zweiten Bereiche übertragen. Auf diese Weise ist die selbstjustierte Anordnung von ersten Bereichen ringförmig um zweite Bereiche erzielbar.

Die Unterdrückung der Beugungseffekte in der fertigen Phasenmaske in einem Belichtungsgerät mit Abbildungsmaßstab m und numerischer Apertur NA ist besonders wirksam, wenn die Ausdehnung der Unterätzung unter die strukturierte Photolackschicht a = (c/m) . λ /NA pro Kante beträgt, wobei c = 0,12 +/- 0,08 ist.

Weitere Ausgestaltungen der Erfindung gehen aus den weiteren Ansprüchen hervor.

Im folgenden wird die Erfindung anhand von Ausführungsbeispielen und der Figuren näher erläutert.
- Fig. 1: zeigt einen Ausschnitt einer Phasenmaske mit einem Träger, der durchgehend aus ein und demselben Material besteht und das mit einem zweiten Bereich, der ringförmig von einem ersten Bereich umgeben ist, versehen ist.
- Fig. 2 bis Fig. 4: zeigt ein Herstellungsverfahren für diese Maske.
- Fig. 5: zeigt einen Ausschnitt einer Phasenmaske, bei der der Träger aus einem Substrat und einer darauf angeordneten Hilfsschicht besteht, und mit einem ersten Bereich, der einen zweiten Bereich ringförmig umgibt.
- Fig. 6 bis Fig. 8: zeigt Herstellungsschritte zu dieser Maske.
- Fig. 9: zeigt einen Ausschnitt einer Phasenmaske mit einem Träger, der durchgehend aus ein und demselben Material besteht, und mit durch lichtabsorbierendes Material getrennten ersten und zweiten Bereichen.
- Fig. 10 bis 12: zeigt Herstellungsschritte für diese Maske.
- Fig. 13: zeigt einen Ausschnitt einer Phasenmaske, bei der der Träger aus einem Substrat und einer darauf angeordneten Hilfsschicht besteht, und mit durch lichtabsorbierendes Material getrennten ersten und zweiten Bereichen. Fig. 14 bis 16 zeigt Herstellungsschritte für diese Maske.

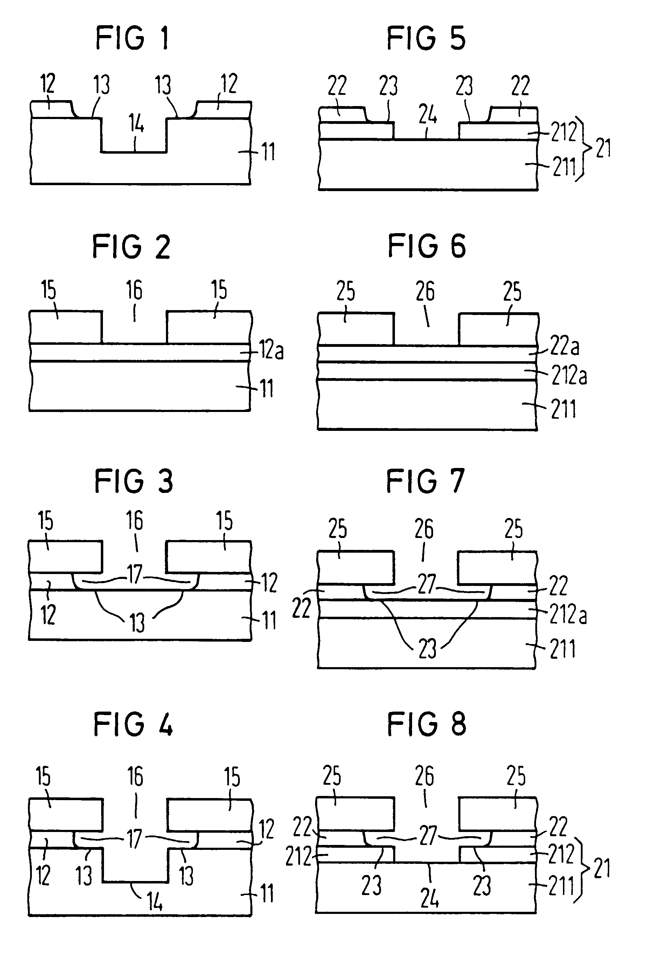

In Fig. 1 ist ein Träger 11 dargestellt, der Träger 11 besteht zum Beispiel aus Quarz. Auf dem Träger 11 ist ein Maskenmuster 12 angeordnet. Das Maskenmuster 12 besteht aus lichtabsorbierendem Material, zum Beispiel aus Chrom. Auf dem Träger 11 gibt es einen ersten Bereich 13 und einen zweiten Bereich 14. Sowohl im ersten Bereich 13 als auch im zweiten Bereich 14 ist die Oberfläche des Trägers 11 freigelegt. Der erste Bereich 13 umgibt den zweiten Bereich 14 ringförmig. Dabei sind der erste Bereich 13 und der zweite Bereich 14 unmittelbar benachbart. Die optische Dicke des Trägers 11 ist im zweiten Bereich 14 um d = λ(1+/- 1/3)/(2(n₂ - n₁)) geringer als im ersten Bereich 13. Dabei ist λ die Wellenlänge des bei der Belichtung verwendeten Lichtes, n₂ ist der Brechungsindex des Trägers und n₁ ist der Brechungsindex des umgebenden Mediums. n₁ ist im Falle von Luft, Vakuum oder Stickstoff als umgebenden Medium 1. Licht, das die Phasenmaske im ersten Bereich 13 durchquert ist gegenüber Licht, das die Phasenmaske im zweiten Bereich 14 durchquert, um 180° +/- 60° phasenverschoben.

Zur Herstellung der Phasenmaske wird auf den Träger 11 eine lichtabsorbierende Schicht 12a aufgebracht. Die lichtabsorbierende Schicht 12a besteht z. B. aus Chrom und weist eine Dicke von etwa 100 nm auf. Auf die lichtabsorbierende Schicht 12a wird eine Photolackschicht aufgebracht und mittels konventioneller optischer Lithographie zu Photolackstrukturen 15 strukturiert. Die Photolackstrukturen 15 weisen eine Öffnung 16 auf. Die Öffnung 16 definiert die laterale Ausdehnung des zweiten Bereiches 14 (s. Fig. 2).

In einem isotropen Ätzprozeß wird die lichtabsorbierende Schicht 12a durch die Öffnung 16 geätzt. Als Ätzmittel ist zum Beispiel Cer-Ammoniumnitrat geeignet. Der isotrope Ätzprozeß ist selektiv zu der Oberfläche des Trägers 11. Die isotrope Ätzung wird überzogen, so daß unter den Photolackstrukturen 15 Unterätzungen 17 entstehen. Durch die Unterätzungen 17 wird die Oberfläche des ersten Bereichs 13 freigelegt (s. Fig. 3). Dabei entsteht aus der lichtabsorbierenden Schicht 12a das Maskenmuster 12.

Zur Erzeugung des zweiten Bereichs 14 (s. Fig. 4) folgt ein anisotroper Ätzprozeß. Dabei wird die Ausdehnung der Öffnung 16 in den Träger 11 übertragen. Als anisotroper Ätzprozeß ist zum Beispiel eine Plasmaätzung mit einem CHF₃/0₂-Gasgemisch geeignet. Die Dauer für den anisotropen Ätzprozeß muß so bemessen sein, daß das Material des Trägers 11 in einer Tiefe d = λ (1+/- 1/3)/(2(n₂ - n₁)) abgetragen wird. Nach Entfernen der Photolackstrukturen 15 entsteht die in Fig. 1 gezeigte Struktur.

In Fig. 5 ist der Ausschnitt einer Phasenmaske dargestellt, die einen zusammengesetzten Träger 21 aufweist. Der Träger 21 enthält ein Substrat 211 und darauf angeordnete Strukturen 212. Das Substrat 211 besteht zum Beispiel aus Quarz mit einer dünnen Abdeckschicht aus ätzresistentem Material, zum Beispiel aus Si₃N₄, und die Strukturen 212 bestehen aus Quarz. Das Substrat 211 kann beispielsweise auch aus Saphir bestehen, die Strukturen 212 bestehen dann aus SiO₂ und/oder Si₃N₄. Es ist ein erster Bereich 23 vorgesehen, in dem die Oberfläche der Strukturen 212 freiliegt. Der erste Bereich 23 umgibt ringförmig einen zweiten Bereich 24, in dem die Oberfläche des Substrats 211 freiliegt. Die Strukturen 212 weisen eine Dicke von d = λ (1+/- 1/3)/2(n₂ - n₁)) auf. Hier ist n₂ der Brechungsindex des Materials der Strukturen 212. Die übrigen Parameter haben die gleiche Bedeutung wie im ersten Ausführungsbeispiel.

Zur Herstellung einer Phasenmaske, von der in Fig. 5 ein Ausschnitt gezeigt ist, wird auf das Substrat 211 eine Hilfsschicht 212a aufgebracht (s. Fig. 6). Die Hilfsschicht 212a besteht aus demselben Material wie die Strukturen 212, das selektiv zur Oberfläche des Substrats 211 ätzbar ist. Auf die Hilfsschicht 212a wird eine lichtabsorbierende Schicht 22a aufgebracht. Auf der lichtabsorbierenden Schicht 22a werden mittels konventioneller optischer Lithographie Photolackstrukturen 25 mit einer Öffnung 26 erzeugt.

Mittels eines isotropen Ätzprozesses wird die lichtabsorbierende Schicht 22a zurückgeätzt. Der isotrope Ätzprozeß ätzt das lichtabsorbierende Material selektiv zu der darunterliegenden Hilfsschicht 212a. Es ist z. B. folgender Ätzprozeß geeignet: Tauchen in Cer-Ammoniumnitrat.

Aus der lichtabsorbierenden Schicht 22a entsteht in diesem Schritt das Maskenmuster 22 (s. Fig. 7). Es entsteht eine Unterätzung 27, in deren Bereich die Oberfläche des ersten Bereichs 23 freigelegt ist.

Mit einem anisotropen Ätzprozeß wird das Muster der Photolackstrukturen 25 in die Hilfsschicht 212a übertragen. Dabei entstehen die Strukturen 212. Das Material der Hilfsschicht 212a wird so gewählt, daß die anisotrope Ätzung mit guter Selektivität zum darunterliegenden Substrat 211 erfolgt. In diesem Fall ist eine Überziehung der Ätzung möglich, wodurch senkrechte Flanken der Strukturen 212 und ein rechter Winkel zwischen den Flanken der Strukturen 212 und dem Substrat 211 erzielbar sind. Bei dem anisotropen Ätzprozeß wird die Oberfläche des Substrats 211 im Bereich des zweiten Bereichs 24 freigelegt (s. Fig. 8). Als anisotroper Ätzprozeß ist insbesondere ein CHF₃/O₂-Plasma mit geringem O₂-Anteil geeignet.

Nach dem Entfernen der Photolackstrukturen 25 ergibt sich die in Fig. 5 dargestellte Struktur.

Mit Hilfe von Simulationsrechnungen, die mit dem Programm Sample 1.7 der Universität Berkeley durchgeführt wurden, wurde ermittelt, daß die Wirkung der Phasenmaske bezüglich der Unterdrückung von Beugungseffekten besonders gut ist, wenn die Unterätzung 17, 27 eine Ausdehnung parallel zur Oberfläche des Trägers von a = (c/m). λ /NA aufweist, wobei m der Abbildungsmaßstab und NA die numerische Apertur eines Belichtungsgerätes, in dem die Phasenmaske eingesetzt wird, darstellt und c eine Konstante ist, deren Wert für die optimale Wirkung der Beugungsunterdrückung zwischen 0,04 und 0,20 liegt. Die Simulationsrechnungen wurden für isolierte Linien, isolierte Spalten und Gitter mit einer Strukturgröße w, was einem k₁ = w · NA/λ = 0,63 entspricht, durchgeführt.

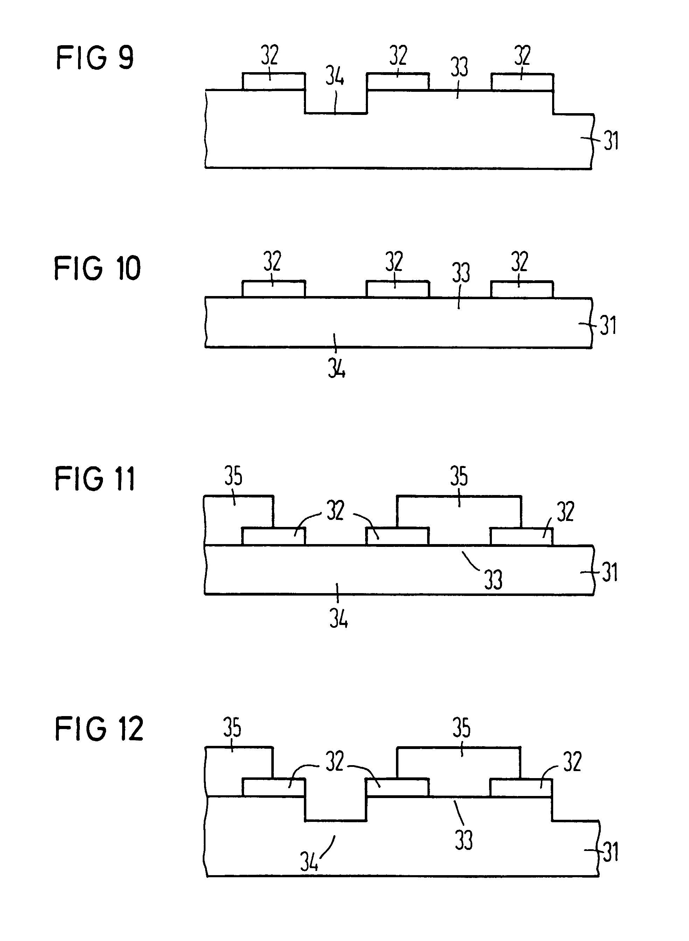

In Fig. 9 ist ein Ausschnitt aus einer Phasenmaske dargestellt mit einem Träger 31 und einem darauf angeordneten Maskenmuster 32. Der Träger 31 weist einen ersten Bereich 33 und einen zweiten Bereich 34 auf. Die optische Dicke des Trägers ist im ersten Bereich 33 um d = λ(1+/- 1/3)/(2(n₂ -n₁)) (Parameter wie bei Fig. 1) größer als im zweiten Bereich 34. Der Träger 31 besteht durchgehend aus Quarz. Das Maskenmuster 32 besteht aus einem lichtabsorbierenden Material, z. B. aus Chrom. Der erste Bereich 33 und der zweite Bereich 34 sind durch einen Teil des Maskenmusters 32 voneinander getrennt.

Zur Herstellung einer Phasenmaske, von der in Fig. 9 ein Ausschnitt gezeigt ist, wird auf dem Träger 31 das Maskenmuster 32 durch konventionelle optische Phototechnik erzeugt. Das Maskenmuster 32 entsteht durch eine isotrope Ätzung, zum Beispiel mit Cer-Ammoniumnitrat, aus einer lichtabsorbierenden Schicht (s. Fig. 10). Das Maskenmuster 32 läßt die Oberfläche des Trägers 31 dort frei, wo der erste Bereich 33 und der zweite Bereich 34 vorgesehen sind.

Auf den Träger 31 mit dem Maskenmuster 32 werden Photolackstrukturen 35 mittels konventioneller Phototechnik erzeugt. Die Photolackstrukturen 35 decken den ersten Bereich 33 ab, während sie die Trägeroberfläche in dem Bereich freilassen, indem der zweite Bereich 34 entstehen soll (s. Fig. 11).

Durch eine anisotrope Ätzung in den Träger 31 wird der zweite Bereich 34 erzeugt (s. Fig. 12). Bei der anisotropen Ätzung wirken die benachbarten Teile des Maskenmusters 32 als Ätzmaske. Der zweite Bereich 33 ist durch die Photolackstruktur 35 geschützt. Die Ätzung in den Träger 31 wird in einer solchen Dauer durchgeführt, daß in einer Tiefe d = λ(1+/- 1/3)/ (2(n₂ - n₁)) das Material des Trägers 31 abgeätzt wird. Als anisotroper Ätzprozeß ist insbesondere zum Beispiel CHF₃/O₂-Plasmaätzen geeignet.

Nach dem Entfernen der Photolackstrukturen 35 ergibt sich die in Fig. 9 gezeigte Struktur.

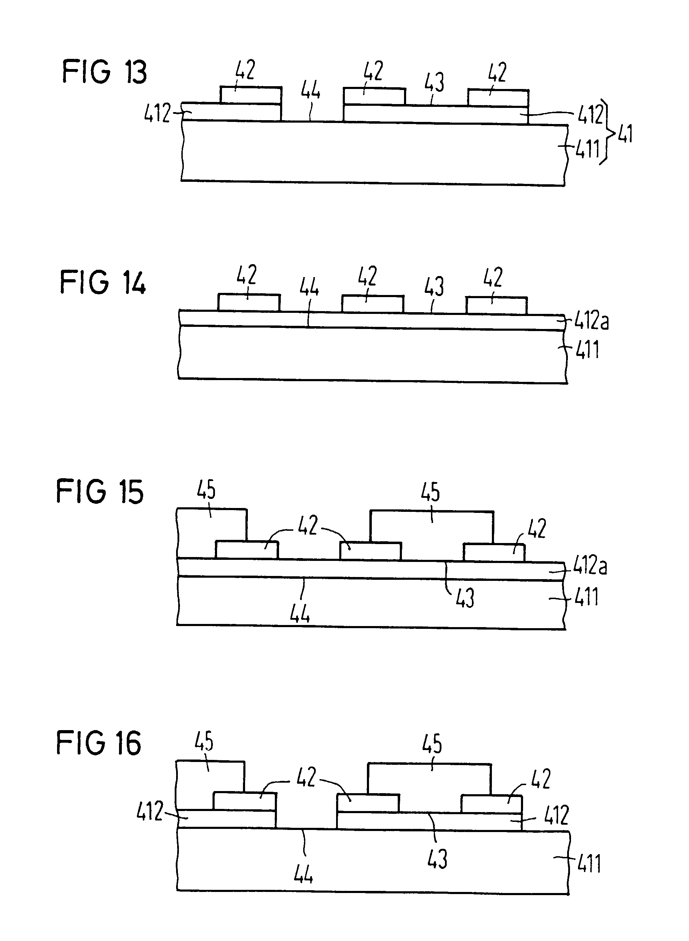

In Fig. 13 ist ein Ausschnitt aus einer Phasenmaske gezeigt, die einen Träger 41 aufweist. Der Träger 41 ist zusammengesetzt aus einem Substrat 411 und aus darauf angeordneten Strukturen 412. Das Substrat besteht zum Beispiel aus Quarz mit einer dünnen ätzresistenten Schicht, zum Beispiel aus Si₃N₄ und die Strukturen 412 aus Quarz. In einem anderen Beispiel besteht das Substrat 411 aus Saphir und die Strukturen aus SiO₂ und/oder Si₃N₄. Auf den Strukturen 412 ist ein Maskenmuster 42 angeordnet. Das Maskenmuster 42 besteht aus lichtabsorbierendem Material, zum Beispiel aus Chrom. Der Träger 41 weist einen ersten Bereich 43 auf, in dem die Oberfläche der Struktur 412 freigelegt ist. Der Träger weist einen zweiten Bereich 44 auf, in dem die Oberfläche des Substrats 411 freigelegt ist. Da die Strukturen 412 eine Dicke von d = λ(1+/- 1/3)/(2(n₂ - n₁)) (Parameter wie in Fig. 5) aufweisen unterscheidet sich die optische Dicke im ersten Bereich von der optischen Dicke im zweiten Bereich des Trägers 41 so, daß durch den ersten Bereich 43 durchgehendes Licht und durch den zweiten Bereich 44 durchgehendes Licht einen Phasenunterschied von 180° +/-60° aufweist.

Zur Herstellung der Phasenmaske, von der in Fig. 13 ein Ausschnitt gezeigt ist, wird auf das Substrat 411 eine Hilfsschicht 412a aus dem Material der Strukturen 412 aufgebracht, das selektiv zur Oberfläche des Substrats 411 ätzbar ist.Das Maskenmuster 42 wird mittels konventioneller optischer Phototechnik und mit isotroper Ätzung erzeugt. Es wird die Oberfläche der Hilfsschicht 412a im Bereich des ersten Bereichs 43 und des zweiten Bereichs 44 freigelegt (s. Fig. 14).

Auf der Hilfsschicht 412a und dem darauf angeordneten Maskenmuster 42 werden mit Hilfe eines Lithographieverfahrens Photolackstrukturen 45 erzeugt. Die Photolackstrukturen 45 decken die Oberfläche der Hilfsschicht 412a in dem Bereich des ersten Bereichs 43 ab. In dem zweiten Bereich 44 ist die Oberfläche der Hilfsschicht 412a unbedeckt (s. Fig. 15).

Das Material der Hilfsschicht 412a ist so gewählt, daß die Hilfsschicht 412a in einem anisotropen Ätzprozeß selektiv zur Oberfläche des Substrats 411 ätzbar ist. Mit Hilfe eines solchen anisotropen Ätzprozesses werden die Strukturen 412 erzeugt (s. Fig. 16). Der zweite Bereich 44 entsteht durch das Abätzen der Hilfsschicht 412a in diesem Bereich. Dabei wirken die benachbarten Maskenmuster 42 als Ätzmaske. Da die Hilfsschicht 412a mit guter Selektivität zur Oberfläche des Substrat 411 ätzbar ist, ist der Unterschied in der optischen Dicke im ersten Bereich 43 und im zweiten Bereich 44 durch die Schichtdicke der Hilfsschicht 412a sehr genau einstellbar.

Nach dem Entfernen der Photolackstrukturen 45 ergibt sich die in Fig. 13 gezeigte Struktur.

In den vier beschriebenen Ausführungsbeispielen wird bei der Herstellung der Phasenmasken lediglich von in der Halbleitertechnologie oder Maskentechnik gebräuchlichen Standardprozeßschritten Gebrauch gemacht. Im ersten und dritten Ausführungsbeispiel werden kommerziell erhältliche Maskenträger verwendet. In allen vier Ausführungsbeispielen tritt als Zusatzprozeßschritt lediglich die anisotrope Maskenätzung auf.

Phasenmasken mit zum Maskenmuster selbstjustiert angeordneten ersten und zweiten Bereichen, wobei die ersten Bereiche die zweiten Bereiche ringförmig umgeben, wie sie anhand der Figuren 1 bis 8 beschrieben worden sind, haben den Vorteil, daß auf der Maske keine trennenden, lichtabsorbierenden Bereiche an den einzelnen Strukturen erforderlich sind. Dadurch wird die Anwendbarkeit erheblich vereinfacht. Phasenmasken entsprechend dem dritten und vierten Ausführungsbeispiel, die anhand der Figuren 9 bis 16 beschrieben wurden, haben ein höheres Potential zur Verbesserung von Auflösung und Prozeßspielräumen.

## Patentansprüche (Patentansprüche für folgende(n) Vertragsstaat(en): DE, FR, GB)

1. Phasenmaske für die Projektionsphotolithographie mit Licht einer Wellenlänge λ zum Einsatz in einem Belichtungsgerat mit einem Abbildungsmaßstab m und einer numerischen Apertur NA mit folgenden Merkmalen:
a) es ist ein Träger (21, 41) aus lichtdurchlässigem Material mit einem darauf angeordneten Maskenmuster (22, 42) aus lichtabsorbierendem Material vorgesehen,
b) der Träger (21, 41) weist außerhalb des Maskenmusters (22, 24) erste Bereiche (23, 43) und zweite Bereiche (24, 44) auf, die von dem lichtabsorbierenden Material unbedeckt sind,
c) bei Belichtung in einem Medium mit Brechungsindex n₁ ist die optische Dicke des Trägers (21, 41) in den zweiten Bereichen (24, 44) um d = λ (1+/-1/3)/(2(n₂-n₁)) geringer als in den ersten Bereichen (23, 43), wobei n₂ der Brechungsindex in den ersten Bereichen (23, 43) ist,
d) der Träger (21, 41) enthält ein Substrat (211, 411) aus lichtdurchlässigem Quarz mit einer ätzresistenten Deckschicht aus Si₃N₄ oder ein substrat aus Saphir, dessen Oberfläche in den zweiten Bereichen (24, 44) freiliegt,
e) auf dem Substrat (211, 411) sind Strukturen (212, 412) aus lichtdurchlässigem Quarz oder aus mindestens einem der Stoffe SiO₂ und Si₃N₄ mit dem Brechungsindex n₂ angeordnet, deren Oberfläche in den ersten Bereichen (23, 43) freiliegt,
f) das Material der Strukturen ist in einem anisotropen Ätzprozeß selektiv zur Oberfläche des Substrats (211, 411) ätzbar.

2. Phasenmaske nach Anspruch 1,
**dadurch gekennzeichnet,**
daß das Maskenmuster (22, 42) aus Chrom mit einer Schichtdikke von mindestens 80 nm besteht.

3. Phasenmaske nach Anspruch 1 oder 2,
**dadurch gekennzeichnet**,
daß es zweite Bereiche (24) gibt, die ringförmig von einem der ersten Bereiche (23) unmittelbar benachbart umgeben sind.

4. Phasenmaske nach Anspruch 3,
**dadurch gekennzeichnet**,
daß der den zweiten Bereich (24) ringförmig umgebende erste Bereich (23) eine radiale Ausdehnung a = (c/m) . λ/NA hat, wobei die Konstante c Werte im Bereich 0,04 ≤ _{c} ≤ 0,20 annimmt.

5. Herstellverfahren für eine Phasenmaske für die Projektionsphotolithographie mit ersten Bereichen und zweiten Bereichen mit der Eigenschaft, daß Licht der Wellenlänge λ nach Durchgang durch die ersten Bereiche und Licht der Wellenlänge λ nach Durchgang durch die zweiten Bereiche gegeneinander um 180° ± 60° phasenverschoben ist, mit folgenden Schritten:
a) zur Herstellung eines Trägers (21, 41) wird auf ein Substrat (211, 411) aus Quarz mit einer dünnen, atzresistenten Deckschicht aus Si₃N₄ oder ein Substrat aus Saphir eine Hilfsschicht (212a, 412a) aus Quarz oder aus einem der Stoffe SiO₂ oder Si₃N₄ aufgebracht, die in einem anisotropen Ätzverfahren selektiv zur Oberfläche des Substrats (211, 411) ätzbar ist, wobei das Material des Substrats und das Material der Hilfsschicht lichtdurchlässig sind und die Hilfsschicht (212a, 412a) eine Dicke von d = λ (1 ± 1/3)/(2(n₂-n₁)) aufweist, wobei n2 der Brechungsindex in den ersten Bereichen und n₁ der Brechungsindex des umgebenden Mediums ist,
b) der Träger (21, 41) wird mit einer lichtabsorbierenden Schicht (12a, 22a) und einer Photolackschicht versehen,
c) nach Strukturierung der Photolackschicht (25, 45) mit konventioneller Maskenlithographie werden die ersten Bereiche (23, 43) durch isotrope Ätzung der lichtabsorbierenden Schicht (22, 42) bis auf die Oberfläche der Hilfsschicht (212a, 412a) erzeugt,
d) durch anisotrope Ätzung der Hilfsschicht (212a, 412a) selektiv zur Oberfläche des Substrats (211, 411) wird die Oberfläche des Substrats (211, 411) freigelegt, wobei die zweiten Bereiche (24, 44) erzeugt werden.

6. Herstellverfahren nach Anspruch 5,
**dadurch gekennzeichnet**,
daß bei der isotropen Ätzung der lichtabsorbierenden Schicht (22a) eine Unterätzung (27) unter die strukturierte Photolackschicht (25) erzeugt wird und daß die anisotrope Ätzung kantenfluchtend mit der strukturierten Photolackschicht (25) erfolgt.

7. Herstellverfahren nach Anspruch 6,
**dadurch gekennzeichnet**,
daß die Unterätzung (27) unter die strukturierte Photolackschicht (25) mit einer Audehnung a = (c/m) . λ/NA unter die Kanten der strukturierten Photolackschicht (25) erzeugt wird, wobei m der Abbildungsmaßstab und NA die numerische Apertur eines Belichtungsgerates, in dem die Phasenmaske verwendet wird, darstellen und c eine Konstante ist, die Werte im Bereich 0,04 ≤ c ≤ 0,20 annimmt.

8. Herstellverfahren nach Anspruch 5,
**dadurch gekennzeichnet**,
daß vor der anisotropen Ätzung in den Träger (31, 41) die ersten Bereiche (33, 43) mit einer weiteren strukturierten Photolackschicht (35, 45) abgedeckt werden.

9. Verfahren nach einem der Ansprüche 5 bis 8,
**dadurch gekennzeichnet**,
daß das Maskenmuster (22, 42) aus Chrom in einer Schichtdicke von mindestens 80 nm erzeugt wird.

## Patentansprüche (Patentansprüche für folgende(n) Vertragsstaat(en): NL, IT)

1. Phasenmaske für die Projektionsphotolithographie mit Licht einer Wellenlänge λ zum Einsatz in einem Belichtungsgerät mit einem Abbildungsmaßstab m und einer numerischen Apertur NA mit folgenden Merkmalen:
a) es ist ein Träger (11, 21, 31, 41) aus lichtdurchlässigem Material mit einem darauf angeordneten Maskenmuster (12, 22, 32, 42) aus lichtabsorbierendem Material vorgesehen,
b) der Träger (11, 21, 31, 41) weist außerhalb des Maskenmusters (12, 22, 23, 24) erste Bereiche (13, 23, 33, 43) und zweite Bereiche (14, 24, 34, 44) auf, die von dem lichtabsorbierenden Material unbedeckt sind,
c) bei Belichtung in einem Medium mit Brechungsindex n₁ ist die optische Dicke des Trägers (11, 21, 31, 41) in den zweiten Bereichen (14, 24, 34, 44) um d = λ (1+/-1/3)/ (2(n₂ - n₁)) geringer als in den ersten Bereichen (13, 23, 33, 43), wobei n₂ der Brechungsindex in den ersten Bereichen (13, 23, 33, 43) ist.

2. Phasenmaske nach Anspruch 1, **dadurch gekennzeichnet**, daß der Träger (11, 31) durchgehend aus ein und demselben Material besteht.

3. Phasenmaske nach Anspruch 2, **dadurch gekennzeichnet**, daß der Träger (11, 31) aus Quarz besteht.

4. Phasenmaske nach Anspruch 1 mit folgenden Merkmalen:
a) der Träger (21, 41) enthält ein Substrat (211, 411) aus einem lichtdurchlässigen ersten Material, dessen Oberfläche in den zweiten Bereichen (24, 44) freiliegt,
b) auf dem Substrat (211, 411) sind Strukturen (212, 412) aus einem lichtdurchlässigen zweiten Material mit dem Brechungsindex n₂ angeordnet, deren Oberfläche in den ersten Bereichen (23, 43) freiliegt,
c) das zweite Material ist in einem anisotropen Ätzprozeß selektiv zur Oberfläche des Substrats (211, 411) ätzbar.

5. Phasenmaske nach Anspruch 4, **dadurch gekennzeichnet**, daß das Substrat (211, 411) aus Quarz mit einer ätzresistenten Deckschicht und die Strukturen (212, 412) aus Quarz bestehen.

6. Phasenmaske nach Anspruch 4, **dadurch gekennzeichnet**, daß das Substrat (211, 411) aus Saphir und die Strukturen (212, 412) aus mindestens einem der Stoffe SiO₂ und Si₃N₄ bestehen.

7. Projektionsmaske nach einem der Ansprüche 1 bis 6, **dadurch gekennzeichnet**, daß das Maskenmuster (12, 22, 32, 42) aus Chrom mit einer Schichtdicke von mindestens 80 nm besteht.

8. Projektionsmaske nach einem der Ansprüche 1 bis 7, **dadurch gekennzeichnet**, daß es zweite Bereiche (14, 24) gibt, die ringförmig von einem der ersten Bereiche (13, 23) unmittelbar benachbart umgeben sind.

9. Projektionsmaske nach Anspruch 8, **dadurch gekennzeichnet**, daß der den zweiten Bereich (14, 24) ringförmig umgebende erste Bereich (13, 23) eine radiale Ausdehnung a = (c/m) . λ /NA hat, wobei die Konstante c Werte im Bereich 0,04 ≦ c ≦ 0,20 annimmt.

10. Herstellverfahren für eine Phasenmaske für die Projektionsphotolithographie mit ersten Bereichen und zweiten Bereichen mit der Eigenschaft, daß Licht der Wellenlänge λ nach Durchgang durch die ersten Bereiche und Licht der Wellenlänge λ nach Durchgang durch die zweiten Bereiche gegeneinander um 180° +/- 60° phasenverschoben ist, mit folgenden Schritten:
a) ein Träger (11, 21, 31, 41) aus lichtdurchlässigem Material wird mit einer lichtabsorbierenden Schicht (12a, 22a) und einer Photolackschicht versehen,
b) nach Strukturierung der Photolackschicht (15, 25, 35, 45) mit konventioneller Maskenlithographie werden die ersten Bereiche (13, 23, 33, 43) durch isotrope Ätzung der lichtabsorbierenden Schicht (12, 22, 32, 42) bis auf die Oberfläche des Trägers (11, 21, 31, 41) erzeugt,
c) durch anisotrope Ätzung des Trägers (11, 21, 31, 41) in einer Tiefe d = λ (1+/- 1/3)/(2(n₂ - n₁)), wobei n₂ der Brechungsindex in den ersten Bereichen und n₁ der Brechungsindex des umgebenden Mediums ist, werden die zweiten Bereiche (14, 24, 34, 44) erzeugt.

11. Herstellverfahren nach Anspruch 10, **dadurch gekennzeichnet,** daß bei der isotropen Ätzung der lichtabsorbierenden Schicht (12a, 22a) eine Unterätzung (17, 27) unter die strukturierte Photolackschicht (15, 25) erzeugt wird und daß die anisotrope Ätzung kantenfluchtend mit der strukturierten Photolackschicht (15, 25) erfolgt.

12. Herstellverfahren nach Anspruch 11, **dadurch gekennzeichnet**, daß die Unterätzung (17, 27) unter die strukturierte Photolackschicht (15, 25) mit einer Ausdehnung a = (c/m) . λ /NA unter die Kanten der strukturierten Photolackschicht (15, 25) erzeugt wird, wobei m der Abbildungsmaßstab und NA die numerische Apertur eines Belichtungsgerätes, in dem die Phasenmaske verwendet wird, darstellen und c eine Konstante ist, die Werte im Bereich 0,04 ≦ c ≦ 0,20 annimmt.

13. Herstellverfahren nach Anspruch 10, **dadurch gekennzeichnet**, daß vor der anisotropen Ätzung in den Träger (31, 41) die ersten Bereiche (33, 43) mit einer weiteren strukturierten Photolackschicht (35, 45) abgedeckt werden.

14. Herstellverfahren nach einem der Ansprüche 10 bis 13, d a d u r c h g e k e n n z e i c h n e t , daß der Träger (21, 41) dadurch hergestellt wird, daß auf ein Substrat (211, 411) aus einem ersten Material eine Hilfsschicht (212a, 412a) aus einem zweiten Material aufgebracht wird, das in einem anisotropen Ätzverfahren selektiv zur Oberfläche des Substrats (211, 411) ätzbar ist.

15. Herstellverfahren nach Anspruch 14, **dadurch gekennzeichnet**, daß das Substrat (211, 411) aus Quarz mit einer dünnen, ätzresistenten Deckschicht besteht und daß die Hilfsschicht (212a, 412a) aus Quarz besteht.

16. Herstellverfahren nach Anspruch 14, **dadurch gekennzeichnet**, daß das Substrat (211, 411) aus Saphir besteht und daß die Hilfsschicht (212a, 412a) aus einem der Stoffe SiO₂ oder Si₃N₄ besteht.

## Claims (Claims for the following Contracting State(s): DE, FR, GB)

1. Phase-shifting mask for projection photolithography using light of a wavelength λ for use in an exposure device with an image scale m and a numeric aperture NA, having the following features:
a) a carrier (21, 41) of transparent material is provided, comprising a mask pattern (22, 42) of light-absorbing material arranged thereon,
b) the carrier (21, 41) exhibits outside the mask pattern (22, 42) first areas (23, 43) and second areas (24, 44) which are not covered by the light-absorbing material,
c) during exposure in a medium having an index of refraction n₁, the optical thickness of the carrier (21, 41) is less by d = λ (1+/-1/3)/(2(n₂-n₁)) in the second areas (24, 44) than in the first areas (23, 43), n₂ being the index of refraction in the first areas (23, 43),
d) the carrier (21, 41) contains a substrate (211, 411) of transparent quartz with an etching-resistant cover layer of Si₃N₄ or a substrate of sapphire, the surface of which is exposed in the second areas (24, 44),
e) on the substrate (211, 411), structures (212, 412) of transparent quartz or of at least one of the substances SiO₂ and Si₃N₄ having an index of refraction of n₂ are arranged, the surface of which structures is exposed in the first areas (23, 43),
f) the material of the structures can be selectively etched with respect to the surface of the substrate (211, 411) in an anisotropic etching process.

2. Phase-shifting mask according to Claim 1, characterized in that the mask pattern (22, 42) consists of chromium having a layer thickness of at least 80 nm.

3. Phase-shifting mask according to Claim 1 or 2, characterized in that there are second areas (24) which are annularly surrounded directly adjacently by one of the first areas (23).

4. Phase-shifting mask according to Claim 3, characterized in that the first area (23) annularly surrounding the second area (24) has a radial extent of a = (c/m) · λ/NA, the constant c assuming values within a range of 0.04 ≤ c ≤ 0.20.

5. Production method for a phase-shifting mask for projection photolithography comprising first areas and second areas having the property that light of a wavelength λ, after passage through the first areas, and light of a wavelength λ, after passage through the second areas, are phase-shifted with respect to one another by 180° ± 60°, comprising the following steps:
a) to produce a carrier (21, 41), an auxiliary layer (212a, 412a) of quartz or of one of the substances SiO₂ or Si₃N₄, which can be selectively etched with respect to the surface of the substrate (211, 411) in an anisotropic etching method, is applied to a substrate (211, 411) of quartz with a thin etching-resistant cover layer of Si₃N₄ or to a substrate of sapphire, the material of the substrate and the material of the auxiliary layer being transparent and the auxiliary layer (212a, 412a) having a thickness of d = λ (1 ± 1/3)/(2(n₂-n₁)), n₂ being the index of refraction in the first areas and n₁ being the index of refraction of the surrounding medium,
b) the carrier (21, 41) is provided with a light-absorbing layer (12a, 22a) and a photoresist layer,
c) after structuring of the photoresist layer (25, 45) by means of conventional mask lithography, the first areas (23, 43) are generated by means of isotropic etching of the light-absorbing layer (22, 42) down to the surface of the auxiliary layer (212a, 412a),
d) the surface of the substrate (211, 411) is exposed by anisotropic etching of the auxiliary layer (212a, 412a) selectively with respect to the surface of the substrate (211, 411), the second areas (24, 44) being produced thereby.

6. Production method according to Claim 5, characterized in that during the isotropic etching of the light-absorbing layer (22a), an underetching (27) is produced below the structured photoresist layer (25), and in that the anisotropic etching occurs with edges aligned with the structured photoresist layer (25).

7. Production method according to Claim 6, characterized in that the underetching (27) below the structured photoresist layer (25) is produced with an extent of a = (c/m) . λ/NA underneath the edges of the structured photoresist layer (25), m being the image scale and NA the numeric aperture of an exposure device in which the phase-shifting mask is used and c being a constant which assumes values within a range of 0.04 ≤ c ≤ 0.20.

8. Production method according to Claim 5, characterized in that, before the anisotropic etching into the carrier (31, 41), the first areas (33, 43) are covered with a further structured photoresist layer (35, 45).

9. Method according to one of Claims 5 to 8, characterized in that the mask pattern (22, 42) is produced from chromium with a layer thickness of at least 80 nm.

## Claims (Claims for the following Contracting State(s): NL, IT)

1. Phase-shifting mask for projection photolithography using light of a wavelength λ for use in an exposure device with an image scale m and a numeric aperture NA, having the following features:
a) a carrier (11, 21, 31, 41) of transparent material is provided, comprising a mask pattern (12, 22, 32, 42) with light-absorbing material arranged thereon,
b) the carrier (11, 21, 31, 41) exhibits outside the mask pattern (12, 22, 23, 24) first areas (13, 23, 33, 43) and second areas (14, 24, 34, 44) which are not covered by the light-absorbing material,
c) during exposure in a medium having an index of refraction n₁, the optical thickness of the carrier (11, 21, 31, 41) is less by d = λ (1+/-1/3)/(2(n₂ - n₁)) in the second areas (14, 24, 34, 44) than in the first areas (13, 23, 33, 43), n₂ being the index of refraction in the first areas (13, 23, 33, 43).

2. Phase-shifting mask according to Claim 1, characterized in that the carrier (11, 31) consists of one and the same material throughout.

3. Phase-shifting mask according to Claim 2, characterized in that the carrier (11, 31) consists of quartz.

4. Phase-shifting mask according to Claim 1, having the following features:
a) the carrier (21, 41) contains a substrate (211, 411) of a transparent first material, the surface of which is exposed in the second areas (24, 44),
b) on the substrate (211, 411), structures (212, 412) of a transparent second material having an index of refraction of n₂ are arranged, the surface of which structures is exposed in the first areas (23, 43),
c) the second material can be selectively etched with respect to the surface of the substrate (211, 411) in an anisotropic etching process.

5. Phase-shifting mask according to Claim 4, characterized in that the substrate (211, 411) consists of quartz with an etching-resistant cover layer and the structures (212, 412) consist of quartz.

6. Phase-shifting mask according to Claim 4, characterized in that the substrate (211, 411) consists of sapphire and the structures (212, 412) consist of at least one of the substances SiO₂ and Si₃N₄.

7. Phase-shifting mask according to one of Claims 1 to 6, characterized in that the mask pattern (12, 22, 32, 42) consists of chromium having a layer thickness of at least 80 nm.

8. Phase-shifting mask according to one of Claims 1 to 7, characterized in that there are second areas (14, 24) which are directly adjacently annularly surrounded by one of the first areas (13, 23).

9. Phase-shifting mask according to Claim 8, characterized in that the first area (13, 23) annularly surrounding the second area (14, 24) has a radial extent of a = (c/m) . λ/NA, the constant c assuming values within a range of 0.04 ≤ c ≤ 0.20.

10. Production method for a phase-shifting mask for projection photolithography comprising first areas and second areas having the property that light of a wavelength λ, after passage through the first areas, and light of a wavelength λ, after passage through the second areas, are phase-shifted with respect to one another by 180° +/- 60°, comprising the following steps:
a) a carrier (11, 21, 31, 41) of transparent material is provided with a light-absorbing layer (12a, 22a) and a photoresist layer,
b) after structuring of the photoresist layer (15, 25, 35, 45) by means of conventional mask lithography, the first areas (13, 23, 33, 43) are generated by means of isotropic etching of the light-absorbing layer (12, 22, 32, 42) down to the surface of the carrier (11, 21, 31, 41),
c) the second areas (14, 24, 34, 44) are generated by anisotropic etching of the carrier (11, 21, 31, 41) to a depth of d = λ(1+/- 1/3)/(2(n₂ - n₁)), n₂ being the index of refraction in the first areas and n₁ being the index of refraction of the surrounding medium.

11. Production method according to Claim 10, characterized in that during the isotropic etching of the light-absorbing layer (12a, 22a), an underetching (17, 27) is produced below the structured photoresist layer (15, 25), and in that the anisotropic etching occurs with edges aligned with the structured photoresist layer (15, 25).

12. Production method according to Claim 11, characterized in that the underetching (17, 27) below the structured photoresist layer (15, 25) is generated with an extent of a = (c/m) . λ/NA underneath the edges of the structured photoresist layer (15, 25), m being the image scale and NA the numeric aperture of an exposure device in which the phase-shifting mask is used and c being a constant which assumes values within a range of 0.04 ≤ c ≤ 0.20.

13. Production method according to Claim 10, characterized in that, before the anisotropic etching into the carrier (31, 41), the first areas (33, 43) are covered with a further structured photoresist layer (35, 45).

14. Production method according to any one of Claims 10 to 13, characterized in that the carrier (21, 41) is produced by an auxiliary layer (212a, 412a) of a second material, which can be selectively etched with respect to the surface of the substrate (211, 411) in an anisotropic etching method, being applied to a substrate (211, 411) of a first material.

15. Production method according to Claim 14, characterized in that the substrate (211, 411) consists of quartz with a thin etching-resistant cover layer and in that the auxiliary layer (212a, 412a) consists of quartz.

16. Production method according to Claim 14, characterized in that the substrate (211, 411) consists of sapphire, and in that the auxiliary layer (212a, 412a) consists of one of the substances SiO₂ or Si₃N₄.

## Revendications (Revendications pour l'(les) Etat(s) contractant(s) suivant(s): DE, FR, GB)

1. Masque à effet de phase pour projection photolithographique à l'aide d'une lumière de longueur d'ondes pour l'utilisation dans un appareil d'exposition avec une échelle d'image m et une ouverture numérique NA, présentant les caractéristiques ci-après:
a) on prévoit un support (21, 41) en une matière translucide, sur lequel est disposé un modèle de masque (22, 42) en une matière absorbant la lumière,
b) le support (21, 41) présente, outre le modèle de masque (22, 24), des premières zones (23, 43) et des secondes zones (24, 44) qui ne sont pas recouvertes par la matière absorbant la lumière,
c) lors de l'exposition dans un milieu à indice de diffraction n₁, la densité optique du support (21, 41) dans les secondes zones (24, 44) est inférieure de d=λ (1+/-1/3)/(2(n₂-n₁)) à celle existant dans les premières zones (23, 43), n₂ représentant l'indice de diffraction dans les premières zones (23, 43),
d) le support (21, 41) contient un substrat (211, 411) constitué par du quartz translucide muni d'une couche de recouvrement résistant aux gravures, constituée de Si₃N₄, ou encore un substrat en saphir dont la surface est mise à nu dans les secondes zones (24, 44),
e) sur le substrat (211, 411), on dispose des structures (212, 412) en quartz translucide ou en au moins une des substances SiO₂ et Si₃N₄, à indice de diffraction n₂, dont la surface est mise à nu dans les premières zones (23, 43),
f) la matière des structures peut être gravée dans un procédé de gravure anisotrope, de manière sélective par rapport à la surface du substrat (211, 411).

2. Masque à effet de phase selon la revendication 1, caractérisé en ce que le modèle de masque (22, 42) est constitué par du chrome possédant une épaisseur de couche d'au moins 80 nm.

3. Masque à effet de phase selon la revendication 1 ou 2, caractérisé en ce qu'il existe des secondes zones (24) qui sont entourées, en position immédiatement voisine, par une des premières zones (23) à la manière d'un anneau.

4. Masque à effet de phase selon la revendication 3, caractérisé en ce que la première zone (23) entourant, à la manière d'un anneau, la seconde zone (24), possède une extension radiale a = (c/m) · λ/NA, où la constante c prend des valeurs dans le domaine de 0,04 ≤ c ≤ 0,20.

5. Procédé de préparation pour un masque à effet de phase pour projection photolithographique, comprenant des premières zones et des secondes zones, présentant la propriété qu'une lumière de longueur d'onde λ après avoir traversé les premières zones et une lumière de longueur d'onde λ après avoir traversé les secondes zones présentent un décalage de phase mutuel de 180° ± 60°, comprenant les étapes ci-après:
a) pour préparer un support (21, 41), on applique sur un substrat (211, 411) en quartz muni d'une couche de recouvrement mince résistant aux gravures en Si₃N₄ ou encore sur un substrat en saphir, une couche auxiliaire (212a, 412a) en quartz ou constituée par une des substances SiO₂ ou Si₃N₄, qui peut être gravée dans un procédé de gravure anisotrope sélectivement par rapport à la surface du substrat (211, 411), la matière du substrat et la matière de la couche auxiliaire étant translucides, et la couche auxiliaire (212a, 412a) présentant une épaisseur de d = λ (1 ± 1/3)/(2(n₂-n₁)), où n₂ représente l'indice de diffraction dans les premières zones et n₁ représente l'indice de diffraction du milieu environnant,
b) le support (21, 41) est muni d'une couche (12a, 22a) absorbant la lumière et d'une couche de photolaque,
c) après structuration de la couche de photolaque (25, 45) à l'aide d'une lithographie à masque conventionnel, on génère les premières zones (23, 43) par gravure isotrope de la couche (22, 42) absorbant la lumière jusqu'à la surface de la couche auxiliaire (212a, 412a),
d) par gravure anisotrope de la couche auxiliaire (212a, 412a) de manière sélective par rapport à la surface du substrat (211, 411), la surface du substrat (211, 411) est mise à nu, ce qui permet d'obtenir les secondes zones (24, 44).

6. Procédé de préparation selon la revendication 5, caractérisé en ce que, lors de la gravure isotrope de la couche (22a) absorbant la lumière, on procède à une gravure sous-jacente (27) en dessous de la couche de photolaque structurée (25) et en ce que la gravure anisotrope a lieu de telle sorte que les arêtes se trouvent à fleur avec celles de la couche de photolaque structurée (25).

7. Procédé de préparation selon la revendication 6, caractérisé en ce qu'on procède à la gravure sous-jacente (27) en dessous de la couche de photolaque structurée (25) avec une extension a = (c/m) . λ/NA, en dessous des arêtes de la couche de photolaque structurée (25), m représentant l'échelle d'image et NA l'ouverture numérique d'un appareil d'exposition dans lequel on utilise le masque à effet de phase, et c est une constante qui prend les valeurs dans le domaine de 0,04 ≤ c ≤ 0,20.

8. Procédé de préparation selon la revendication 5, caractérisé en ce qu'avant la gravure anisotrope dans le support (31, 41), on recouvre les premières zones (33, 43) à l'aide d'une couche de photolaque structurée supplémentaire (35, 45).

9. Procédé selon l'une quelconque des revendications 5 à 8, caractérisé en ce qu'on obtient le modèle de masque (22, 42) à partir de chrome avec une épaisseur de couche d'au moins 80 nm.

## Revendications (Revendications pour l'(les) Etat(s) contractant(s) suivant(s): NL, IT)

1. Masque à effet de phase pour projection photolithographique à l'aide d'une lumière de longueur d'onde λ pour l'utilisation dans un appareil d'exposition avec une échelle d'image m et une ouverture numérique NA, présentant les caractéristiques ci-après:
a) on prévoit un support (11, 21, 31, 41) en une matière translucide, sur lequel est disposé un modèle de masque (12, 22, 32, 42) en une matière absorbant la lumière,
b) le support (11, 21, 31, 41) présente, outre le modèle de masque (12, 22, 23, 24), des premières zones (13, 23, 33, 43) et des secondes zones (14, 24, 34, 44) qui ne sont pas recouvertes par la matière absorbant la lumière,
c) lors de l'exposition dans un milieu à indice de diffraction n₁, la densité optique du support (11, 21, 31, 41) dans les secondes zones (14, 24, 34, 44) est inférieure de d =λ (1+/-1/3)/(2(n₂-n₁)) à celle existant dans les premières zones (13, 23, 33, 43), n₂ représentant l'indice de diffraction dans les premières zones (13, 23, 33, 43),

2. Masque à effet de phase selon la revendication 1, caractérisé en ce que le support (11, 31) est constitué en continu par une seule et même matière.

3. Masque à effet de phase selon la revendication 2, caractérisé en ce que le support (11, 31) est constitué par du quartz.

4. Masque à effet de phase selon la revendication 1, présentant les caractéristiques ci-après:
a) le support (21, 41) contient un substrat (211, 411) constitué par une première matière translucide dont la surface est mise à nu dans les secondes zones (24, 44),
b) sur le substrat (211, 411), on dispose des structures (212, 412) en une seconde matière translucide possédant un indice de diffraction n₂ dont la surface est mise à nu dans les premières zones (23, 43),
c) la seconde matière peut être gravée dans un premier procédé de gravure anisotrope de manière sélective par rapport à la surface du substrat (211, 411).

5. Masque à effet de phase selon la revendication 4, caractérisé en ce que le substrat (211, 411) est constitué de quartz muni d'une couche de recouvrement résistant aux gravures et les structures (212, 412) sont constituées de quartz.

6. Masque à effet de phase selon la revendication 4, caractérisé en ce que le substrat (211, 411) est constitué de saphir et les structures (212, 412) sont constituées par au moins une des substances SiO₂ et Si₃N₄.

7. Masque à effet de phase selon l'une quelconque des revendications 1 à 6, caractérisé en ce que le modèle de masque (12, 22, 32, 42) est constitué par du chrome possédant une épaisseur de couche d'au moins 80 nm.

8. Masque à effet de phase selon l'une quelconque des revendications 1 à 7, caractérisé en ce qu'il existe des secondes zones (14, 24) qui sont entourées, en position immédiatement voisine, par une des premières zones (13, 23) à la manière d'un anneau.

9. Masque à effet de phase selon la revendication 8, caractérisé en ce que la première zone (13, 23) entourant, à la manière d'un anneau, la seconde zone (14, 24), possède une extension radiale a = (c/m) . λ/NA, où la constante c prend des valeurs dans le domaine de 0,04 ≤ c ≤ 0,20.

10. Procédé de préparation pour un masque à effet de phase pour projection photolithographique, comprenant des premières zones et des secondes zones, présentant la propriété qu'une lumière de longueur d'onde λ après avoir traversé les premières zones et une lumière de longueur d'onde λ après avoir traversé les secondes zones présentent un décalage de phase mutuel de 180° ± 60°, comprenant les étapes ci-après:
a) on munit un support (11, 21, 31, 41) constitué d'une matière translucide, d'une couche (12a, 22a) absorbant la lumière et d'une couche de photolaque,
b) après structuration de la couche de photolaque (15, 25, 35, 45) à l'aide d'une lithographie conventionnelle à masque, on génère les premières zones (13, 23, 33, 43) par gravure isotrope de la couche (12, 22, 32, 42) absorbant la lumière jusqu'à la surface du support (11, 21, 31, 41),
c) par gravure anisotrope du support (11, 21, 31, 41) à une profondeur d = λ (1 ± 1/3)/(2(n₂-n₁)), où n2 représente l'indice de diffraction dans les premières zones et n₁ représente l'indice de diffraction du milieu environnant, on génère les secondes zones (14, 24, 34, 44).

11. Procédé de préparation selon la revendication 10, caractérisé en ce que, lors de la gravure isotrope de la couche (12a, 22a) absorbant la lumière, on procède à une gravure sous-jacente (17, 27) en dessous de la couche de photolaque structurée (15, 25) et en ce que la gravure anisotrope a lieu de telle sorte que les arêtes sont disposées à fleur avec celles de la couche de photolaque structurée (15, 25).

12. Procédé de préparation selon la revendication 11, caractérisé en ce qu'on procède à la gravure sous-jacente (17, 27) en dessous de la couche de photolaque structurée (15, 25) avec une extension a = (c/m) · λ/NA, en dessous des arêtes de la couche de photolaque structurée (15, 25), m représentant l'échelle d'image et NA l'ouverture numérique d'un appareil d'exposition dans lequel on utilise le masque à effet de phase, et c est une constante qui prend des valeurs dans le domaine de 0,04 ≤ c ≤ 0,20.

13. Procédé de préparation selon la revendication 10, caractérisé en ce qu'avant la gravure anisotrope dans le support (31, 41), on recouvre les premières zones (33, 43) à l'aide d'une couche de photolaque structurée supplémentaire (35, 45).

14. Procédé selon l'une quelconque des revendications 10 à 13, caractérisé en ce qu'on prépare le support (21, 41) en appliquant sur un substrat (211, 411) constitué par une première matière, une couche auxiliaire (212a, 412a) constituée par une seconde matière qui peut être gravée dans un procédé de gravure anisotrope sélectivement par rapport à la surface du substrat (211, 411).

15. Procédé selon la revendication 14, caractérisé en ce que le substrat (211, 411) est constitué de quartz muni d'une couche mince de recouvrement résistant aux gravures et en ce que la couche auxiliaire (212a, 412a) est constituée de quartz.

16. Procédé selon la revendication 14, caractérisé en ce que le substrat (211, 411) est constitué de saphir et en ce que la couche auxiliaire (212a, 412a) est constituée par une des substances SiO₂ ou Si₃N₄.
